Europäisches Patentamt

European Patent Office

Office européen des brevets

(1) Publication number: **0 114 492**
**B1**

(12) **EUROPEAN PATENT SPECIFICATION**

(45) Date of publication of patent specification: **08.03.89**

(51) Int. Cl.⁴: **G 11 C 7/00, G 11 C 11/24**

(21) Application number: **83307728.2**

(22) Date of filing: **19.12.83**

(54) Semiconductor memory device having active pull-up circuits.

(30) Priority: **22.12.82 JP 223678/82**

(43) Date of publication of application:
**01.08.84 Bulletin 84/31**

(45) Publication of the grant of the patent:
**08.03.89 Bulletin 89/10**

(84) Designated Contracting States:
**DE FR GB**

(56) References cited:
IBM TECHNICAL DISCLOSURE BULLETIN, vol.
24, no. 10, March 1982, pages 5242-5244, New
York, US; P.C. TIEN: "Differential sense
amplifier for unbalanced data lines"
PATENTS ABSTRACTS OF JAPAN, vol. 2, no.
150, 15th December 1978, page 9709 E 78; & JP
- A - 53 120 238 (MITSUBISHI DENKI K.K.)
20-10-1978

(73) Proprietor: **FUJITSU LIMITED**
**1015, Kamikodanaka Nakahara-ku**
**Kawasaki-shi Kanagawa 211 (JP)**

(72) Inventor: **Mochizuki, Hirohiko**
**2393-1-401, Arima Miyamae-ku**
**Kawasaki-shi Kanagawa 213 (JP)**
Inventor: **Takemae, Yoshihiro**
**8-13-24-303, Akasaka Minato-ku**
**Tokyo 107 (JP)**
Inventor: **Nakano, Tomio**
**1-11-2-12-404 Shirahatadai Miyamae-ku**
**Kawasaki-shi Kanagawa 213 (JP)**
Inventor: **Sato, Kimiaki**
**4-11-35-204 Minamiazabu**
**Minato-ku Tokyo (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to a semiconductor memory device and, more particularly, to an active pull-up circuit of a metal-oxide semiconductor (MOS) (broadly, MIS) dynamic random access memory (RAM) device.

In dynamic RAM devices in which one-transistor one-capacitor type memory cells are mainly used, one sense amplifier for the read operation is provided for each bit line pair. Therefore, when a memory cell is selected so as to generate only a small difference in potential between a pair of bit lines, the sense amplifier enlarges, i.e., amplifies the above-mentioned small difference in potential by pulling down the lower side of the potentials of the bit lines. However, even in this case, the higher side of the potentials of the bit lines falls a little due to the discharge at the sense amplifier immediately after the start of the sense operation, and to the leak currents after the completion of the operation, and the like. This is disadvantageous in that the level for rewriting data into a memory cell is low. An active pull-up circuit is provided to pull up the higher side of the potentials of the bit lines again.

An active pull-up circuit for each bit line basically comprises three elements, i.e., a first transistor connected between a bit line and a power supply, a second transistor connected between the gate of the first transistor and the bit line, and a capacitor connected to the gate of the first transistor. To drive this active pull-up circuit, a clock signal for controlling the gate potential of the second transistor, and a clock signal for controlling the capacitor potential are necessary. However, in recent years, there has been proposed an active pull-up circuit in which the gate of the second transistor is connected to the other bit line of the pair connected to the sense amplifier, so that the gate potential of the second transistor is controlled by the potential of this bit line. JP—A—53—120238 describes such an active pull-up circuit. Such an active pull-up circuit extending over two bit lines has an advantage in that the control is simple, since the number of clock signals is reduced.

In the above-mentioned active pull-up circuit extending over two bit lines, as explained later, when a write operation for reverse data is carried out after an active pull-up operation, it is impossible to carry out an active pull-up operation again. Therefore, the higher of the potentials of the bit lines is not pulled up, and as a result, the reduction of the higher of the potentials of the bit lines affects the following refresh operation. In addition, if the higher of the potentials of the bit lines is further reduced, the stored information can be erased in the worst case.

According to this invention such an active pull-up circuit includes means connected to the gate of the first transistor and to the corresponding bit line, for transmitting a high level potential of the corresponding bit line to the gate of the first transistor.

In a semiconductor memory device having such an active pull-up circuit an active pull-up operation is again possible when a write operation for reverse data is carried out after an active pull-up operation.

Particular embodiments of semiconductor memory devices in accordance with this invention will now be described and contrasted with the prior art with reference to the accompanying drawings; in which:—

Figure 1 is a circuit diagram of a general dynamic RAM device;

Figure 2 is a circuit diagram of a prior art semiconductor memory device incorporating active pull-up circuits;

Figures 3A to 3F are timing diagrams explaining the operation of the prior art circuit;

Figure 4 is a circuit diagram of a first embodiment of the semiconductor memory device according to the present invention;

Figures 5A to 5I are timing diagrams explaining the operation of the circuit shown in Figure 4;

Figure 6 is a diagram of a circut for generating the pull-up signal $\phi_{AP}$;

Figures 7A to 7J are timing diagrams explaining the operating of the circuit shown in Figure 6; and

Figures 8 and 9 are circuit diagrams of second and third embodiments of the semiconductor memory device incorporating active pull-up circuits according to the present invention.

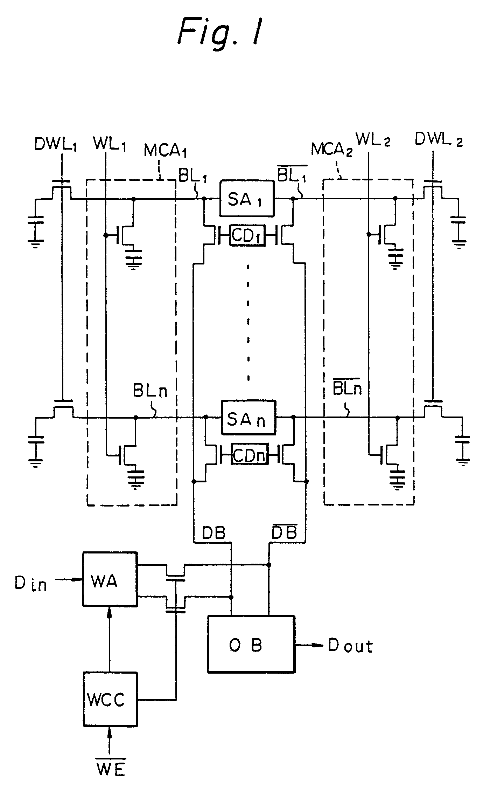

In Fig. 1, which illustrates a schematic view of a general dynamic RAM device, sense amplifiers $SA_1$ to $SA_n$ are arranged between memory cell arrays $MCA_1$ and $MCA_2$ in which a large number of memory cells of a one-transistor one-capacitor type are arranged in a matrix, and bit line pairs $BL_1$ and $\overline{BL}_1$;...; and $BL_n$ and $\overline{BL}_n$ are connected to both sides of the sense amplifiers $SA_1$ through $SA_n$. A memory cell is provided at each intersection between the bit lines $BL_1$, $\overline{BL}_1$,..., $BL_n$, and $\overline{BL}_n$, and the word lines $WL_1$, $WL_2$,.... In addition, a dummy cell is provided at each intersection between the bit lines $BL_1$, $\overline{BL}_1$,..., $BL_n$, $\overline{BL}_n$, and dummy word lines $DWL_1$ and $DWL_2$.

Column decoders $CD_1$ through $CD_n$ are arranged at the bit lines $BL_1$, $\overline{BL}_1$,...$BL_n$, and $\overline{BL}_n$. One row of memory cells are selected by one of the word lines, and each of the data signals derived from the cells on the corresponding bit lines $BL_1$...$\overline{BL}_n$ is then amplified by one of the sense amplifiers $SA_1$ through $SA_n$. Further, memory cell information amplified by the sense amplifier is selected by the column decoders and is transmitted as data $D_{out}$ via data buses DB and $\overline{DB}$ from an output buffer OB to the exterior. On the other hand, write data $D_{in}$ is supplied from the exterior to a write amplifier WA which is controlled by a write control circuit WCC to which a write enable signal $\overline{WE}$ is applied. Thus, information is written into a memory cell connected between the bit line selected by the column decoders $CD_1$ through $CD_n$ and the word line selected by word decoders (not shown).

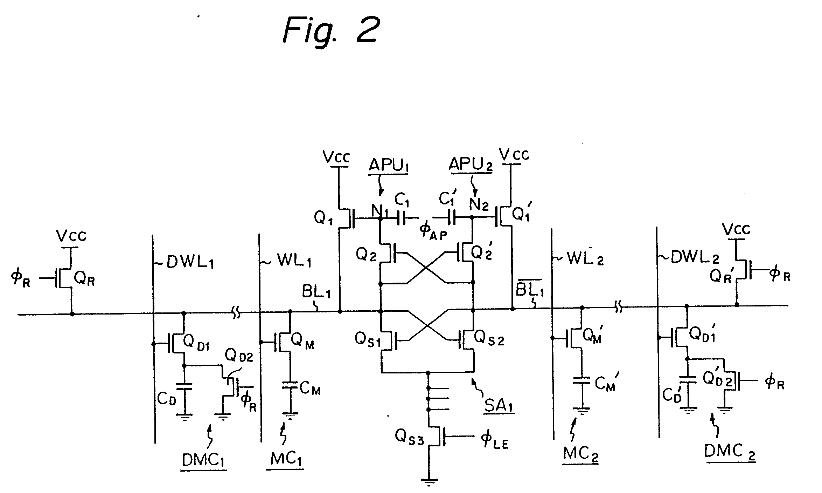

In Fig. 2, which illustrates a circuit diagram of a semiconductor memory device incorporating a prior art active pull-up circuit, only two bit lines $BL_1$ and $\overline{BL_1}$ are illustrated. A sense amplifier $SA_1$ formed by cross-coupled transistors $Q_{S1}$ and $Q_{S2}$ is provided between the bit lines $BL_1$ and $\overline{BL_1}$. This sense amplifier $SA_1$ is controlled by the transistor $Q_{S3}$ which is common to the other sense amplifiers.

Disposed at intersections between the word lines $WL_1$ and $WL_2$, and the bit lines $BL_1$ and $\overline{BL_1}$ are one-transistor one-capacitor type memory cells $MC_1$ and $MC_2$. In this case, each memory cell comprises one transistor $Q_M$ ($Q_M'$) and one capacitor $C_M$ ($C_M'$). Also, disposed at intersections between dummy word lines $DWL_1$ and $DWL_2$, and the bit lines $BL_1$ and $BL_2$, are dummy cells $DMC_1$ and $DMC_2$. In this case, each dummy cell comprises two transistors $Q_{D1}$ and $Q_{D2}$ ($Q_{D1}'$ and $Q_{D2}'$) and one capacitor $C_D$ ($C_D'$). In addition, the capacitance of the capacitor $C_D$ ($C_D'$) of the dummy cell is set to be almost half of that of the capacitor $C_M$ ($C_M'$) of the memory cells.

Transistors $Q_R$ and $Q_R'$ are used for precharging the bit lines $BL_1$ and $\overline{BL_1}$.

Provided at the bit lines $BL_1$ and $\overline{BL_1}$ are active pull-up circuits $APU_1$ and $APU_2$. Each active pull-up circuit comprises three elements, i.e., a first transistor $Q_1$ connected between the power supply terminal $V_{CC}$ and the bit line $BL_1$, a second transistor $Q_2$ connected between the gate (node $N_1$) of the first transistor $Q_1$ and the bit line $BL_1$, and a capacitor $C_1$ connected to the node $N_1$.

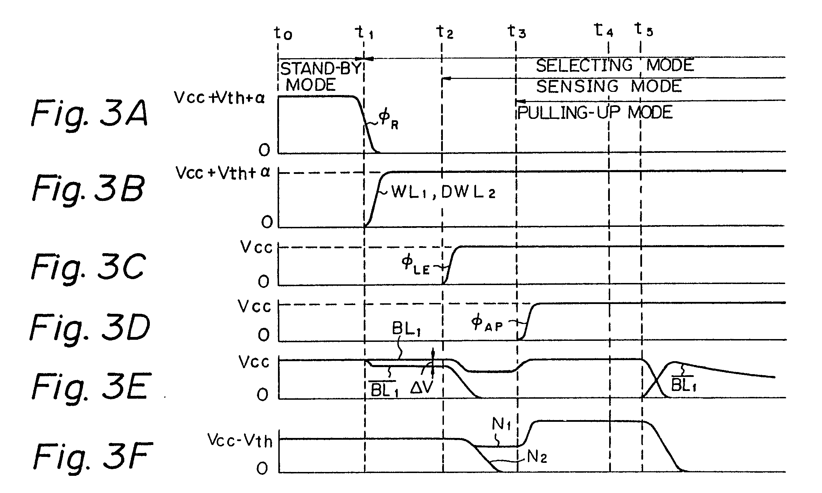

The operation of the circuit shown in Fig. 2 will be explained with reference to Figs. 3A through 3F. As an initial set, assume that a high level ($V_{CC}$ level) is stored in the capacitor $C_M$ of the memory cell $MC_1$.

During a stand-by mode (from $t_0$ to $t_1$), as illustrated in Fig. 3A, the reset clock signal $\phi_R$ is caused to be $V_{CC}+V_{th}+\alpha$. Here, $V_{th}$ designates a common threshold voltage of the N-channel enhancement type transistors in Fig. 2. As a result, as illustrated in Fig. 3E, the bit lines $BL_1$ and $\overline{BL_1}$ are both precharged at $V_{CC}$, and simultaneously, the capacitors $C_D$ and $C_D'$ of the dummy cells $DMC_1$ and $DMC_2$ are discharged. At this time, the potentials at the nodes $N_1$ and $N_2$ remain at $V_{CC}-V_{th}$.

At time $t_1$, as illustrated in Figs. 3A and 3B, the reset clock signal $\phi_R$ is lowered from $V_{CC}+V_{th}+\alpha$ to 0, and then the word line $WL_1$ and the dummy word line $DWL_2$ is raised from 0 to $V_{CC}+V_{th}+\alpha$. As a result, the operation moves from the stand-by mode to a selecting mode. That is, the memory cell $MC_1$ is connected to the bit line $BL_1$, and the dummy cell $DMC_2$ is connected to the bit line $\overline{BL_1}$, so that the potentials at the bit lines $BL_1$ and $\overline{BL_1}$ change. However, in this case, since the capacitor $C_M$ of the memory cell $MC_1$ was already charged to $V_{CC}$, the potential at the bit line $BL_1$ remains at $V_{CC}$. On the other hand, the potential at the bit line $\overline{BL_1}$ is reduced due to the presence of the discharged capacitor $C_D'$. As a result, as illustrated in Fig. 3E, there is generated a very small difference $\Delta V$ in potential.

Next, at time $t_2$, as illustrated in Fig. 3C, when a latch enable signal $\phi_{LE}$ is changed from 0 to $V_{CC}$, the transistor $Q_{S3}$ is turned on so as to initiate the operation of the sense amplifier $SA_1$, so that the operation moves into a sensing mode. In this case, since the potential at the bit line $BL_1$ is larger than the potential $\overline{BL_1}$, the conductivity of the transistor $Q_{S2}$ rapidly increases to reduce the lower side potential, i.e., the potential at the bit line $\overline{BL_1}$, to zero. On the other hand, since the transistor $Q_{S1}$ is turned off, the higher side potential, i.e., the potential at the bit line $BL_1$ is not reduced, however, it is actually a little reduced as illustrated in Fig. 3E, due to the discharge by the transistor $Q_{S1}$ of the sense amplifier $SA_1$ immediately after the start of the sensing operation, and the leak currents after the completion of the sensing operation, and the like. As a result, as illustrated in Fig. 3F, the potentials at the nodes $N_1$ and $N_2$ also reduce, since these potentials follow the potentials at the bit lines $BL_1$ and $\overline{BL_1}$.

Next, at time $t_3$, as illustrated in Fig. 3D, a pull-up signal $\phi_{AP}$ is changed from 0 to $V_{CC}$, so that the operation moves into a pulling-up mode. At this time, on the side of the node $N_1$, since the transistor $Q_2$ is turned off, the potential at the node $N_1$ follows the pull-up signal $\phi_{AP}$ due to the capacitive coupling of the capacitor $C_1$. As a result, the gate potential of the transistor $Q_1$ becomes higher than $V_{CC}$, and accordingly, the potential at the bit line $BL_1$ also becomes at $V_{CC}$. Thus, a pulling-up operation is carried out. On the other hand, on the side of the node $N_2$, since the transistor $Q_2'$ is turned on, the potential at the node $N_2$ never increases so that the transistor $Q_1'$ is never turned on. Therefore, the potential at the bit line $\overline{BL_1}$ remains at 0.

Thus, the usual operation has been explained. However, at time $t_5$ after the pulling-up operation during the same sensing mode, when a write operation of reverse data from the write amplifier WA in Fig. 1 is carried out, the transistors $Q_2$ and $Q_{S1}$ are turned on so that the potential at the node $N_1$ reduces to 0, as illustrated in Fig. 3F. On the other hand, the transistors $Q_2'$ and $Q_{S2}$ are rapidly turned off, even before the potential at the node $N_2$ is raised by the high level of the bit line $\overline{BL_1}$ through the transistor $Q_2'$. It often happens that, after the rewriting operation, the charges at the bit line $\overline{BL_1}$ leak from the transistor $Q_{S2}$ and other transistors connected to this bit line $\overline{BL_1}$ due to the effects of noise junction leakage. Therefore, as illustrated in Fig. 3E, the potential at the bit line $\overline{BL_1}$, tends to decrease gradually. Therefore, also in this case, a pulling-up operation is necessary. However, it is impossible to selectively actuate the pull-up transistor $Q_1'$ even if the pull-up signal $\phi_{AP}$ is raised, because the potential at the node $N_2$ reamins at 0. Therefore, the transistor $Q_1'$ is never turned on, and accordingly, a pulling-up operation cannot be again carried out. Note that, even when the pull-up signal $\phi_{AP}$ is caused to be 0 and thereafter is caused to be $V_{CC}$, a pulling-up operation cannot be again carried out in Fig. 2 also.

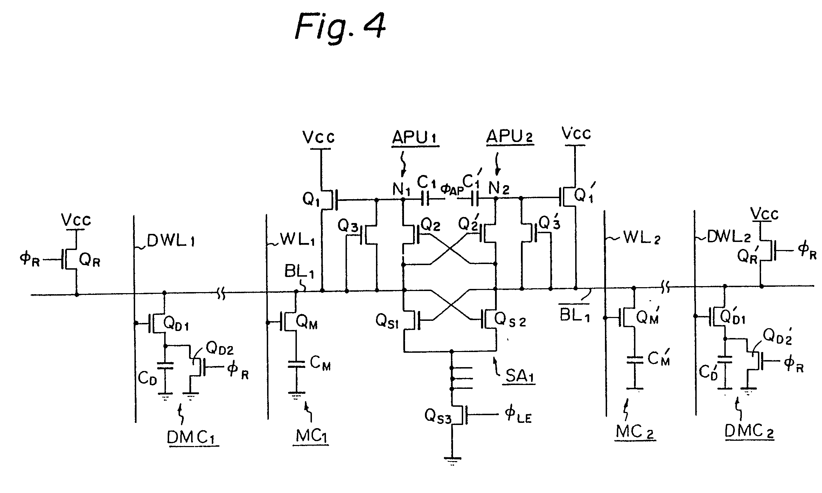

In Fig. 4, which illustrates a first embodiment of the present invention, third transistors $Q_3$ and $Q_3'$

are added to the active pulling-up circuits $APU_1$ and $APU_2$ in Fig. 2, respectively. The gates of the transistors $Q_3$ and $Q_3'$ are connected to the drains thereof, and therefore, these transistors serve as diodes. That is, the transistors $Q_3$ and $Q_3'$ transmit only the higher of the potentials of the bit lines $BL_1$ and $\overline{BL}_1$ to the nodes $N_1$ or $N_2$. The presence of the transistors $Q_3$ and $Q_3'$ does not affect the usual pulling-up operation, but affect the operation after a write operation of reverse data is carried out after or during the pulling-up operation.

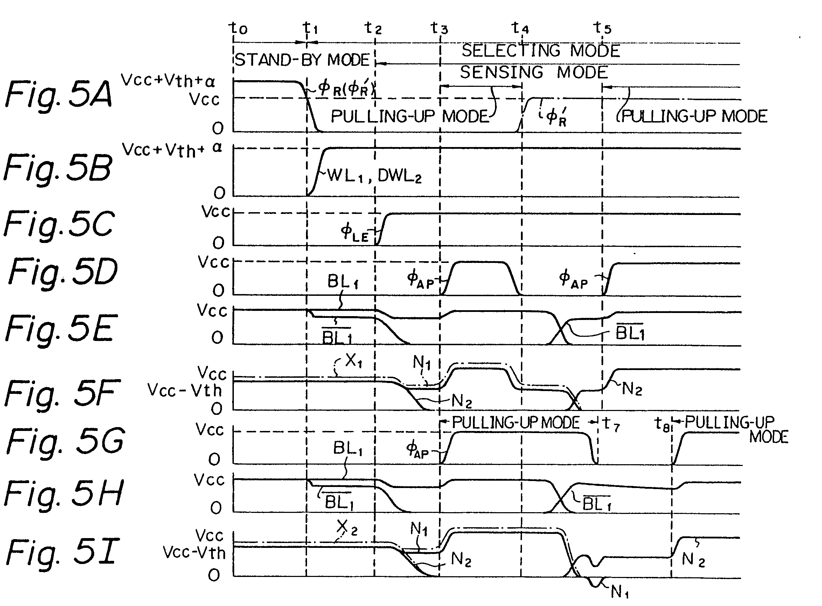

The operation of the circuit shown in Fig. 4 will be explained with reference to Figs. 5A through 5F. Figures 5A through 5F correspond to Fig. 3A to 3F, respectively, and the operation before the write operation of reverse data, i.e., before time $t_5$, is the same as that on Figs. 3A to 3F.

At time $t_5$, as illustrated in Fig. 5E, when a write operation of reverse data is carried out, the potential of the bit line $BL_1$ becomes 0 so as to quickly turn off both of the transistors $Q_2'$ and $Q_{S2}$ so that the high level of the bit line $\overline{BL}_1$ is not transmitted to the node $N_2$ through the transistor $Q_2'$, however, the high level potential of the bit line $\overline{BL}_1$ is transmitted via the transistor $Q_3'$ to the node $N_2$. Therefore, as illustrated in Fig. 5F, the potential of node $N_2$ increases to a level which is the potential at the bit line $\overline{BL}_1$ minus $V_{th}$. On the other hand, the transistors $Q_2$ and $Q_{S1}$ are turned on, so that the potential at the node $N_1$ decreases and the potential at the node $N_1$ becomes 0. Therefore, the potential at the node $N_1$ never increases.

Next, at time $t_6$, when the pull-up signal $\phi_{AP}$ is again increased from 0 to $V_{CC}$, the potential at the node $N_2$ is pulled up to a level sufficiently higher than $V_{CC}$ due to the capacitive coupling of the capacitor $C_1'$, as illustrated in Fig. 5F. As a result, the transistor $Q_1'$ is turned on, so that the potential at the bit line $\overline{BL}_1$ becomes $V_{CC}$, as illustrated in Fig. 5E. Thus, a pulling-up operation is carried out.

Figures 5G through 5I are modifications of Figs. 5D through 5F, respectively. That is, in Figs. 5G through 5I, a write operation of reverse data is carried out during the pulling-up operation. Contrary to this, in Figs. 5G through 5I, at time $t_7$, when the pull-up signal $\phi_{AP}$ is changed from $V_{CC}$ to 0 so as to release the pulling-up operation, the potentials at the nodes $N_1$ and $N_2$ are both reduced at one time due to the capacitive coupling of the capacitor $C_1$ and $C_1'$, as illustrated in Fig. 5I, but return to their previous state. Therefore, at time $t_8$, when the pull-up signal $\phi_{AP}$ is increased from 0 to $V_{CC}$, a normal pulling-up operation is carried out.

Thus, even when a write operation is carried out after or during a pulling-up operation, a pulling-up operation thereafter is normally carried out.

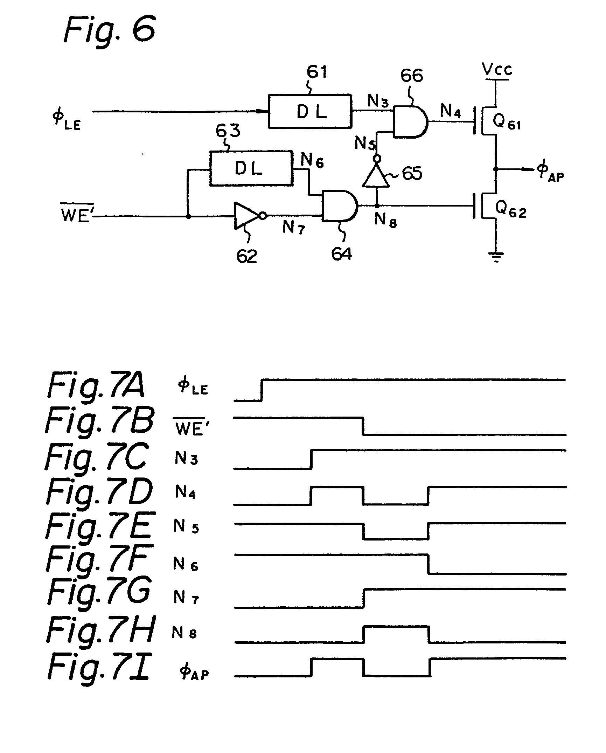

The pull-up signal $\phi_{AP}$ shown in Fig. 5D or 5G can be generated by a simple logic circuit. An example thereof is illustrated in Fig. 6.

In Fig. 6, reference numeral 61 designates a delay circuit, 62 an inverter, 63 a delay circuit, 64 an AND circuit, 65 an inverter, 66 an AND circuit, and $Q_{61}$ and $Q_{62}$ N-channel enhancement type transistors. Reference $\phi_{LE}$ designates the latch enable signal shown in Fig. 5C and $\overline{WE}'$ corresponds to the $\overline{Q}$ output of a flip-flop (not shown) triggered by a write enable signal $\overline{WE}$. The operation of the circuit shown in Fig. 6 can be easily understood from the timing diagrams shown in Figs. 7A through 7I, and the detailed explanation thereof are omitted.

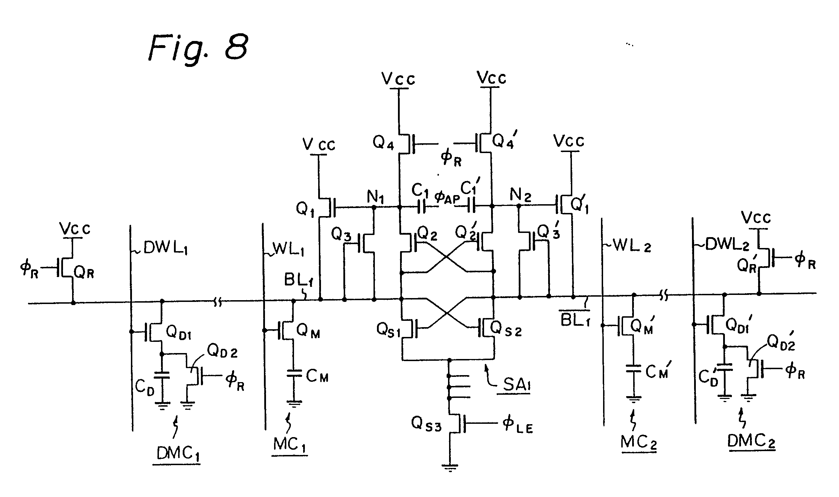

In Fig. 8, which illustrates a second embodiment of the present invention, fourth transistors $Q_4$ and $Q_4'$ are added to the active pull-up circuits $APU_1$ and $APU_2$, respectively, shown in Fig. 4. The transistors $Q_4$ and $Q_4'$ are connected between the power supply terminal $V_{CC}$, and the nodes $N_1$ and $N_2$, and the gate potentials of these transistors are controlled by a reset clock signal $\phi_R$. That is, during the stand-by mode (from $t_0$ to $t_1$), since the reset clock signal $\phi_R$ is $V_{CC}+V_{th}+\alpha$. The potentials at the nodes $N_1$ and $N_2$ are both pulled up to $V_{CC}$, as indicated by $X_1$ shown in Fig. 5F or $X_2$ shown in Fig. 5I. Therefore, during the pulling-up mode (from $t_2$ to $t_4$), the increase of the potential at the node (in this case, $N_1$) due to the pulling-up signal $\phi_{AP}$ becomes larger so that a more efficient pulling-up operation is effected. In turn, this decreases the load of the clock signal $\phi_{AP}$ and dispenses with a large driving power of the pulling-up signal $\phi_{AP}$.

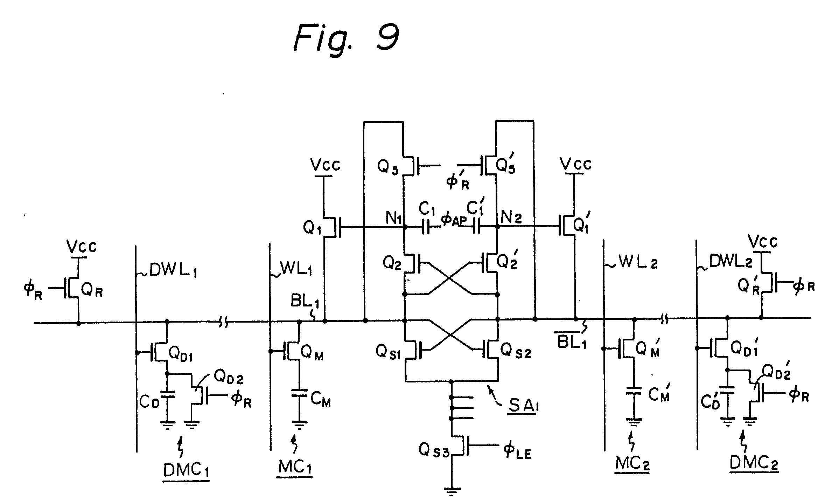

In Fig. 9, which illustrates a third embodiment of the present invention. In Fig. 9, fifth transistors $Q_5$ and $Q_5'$ are provided instead of the third transistors $Q_3$ and $Q_3'$ and the fourth transistors $Q_4$ and $Q_4'$ in Fig. 8. The gate potentials of the transistors $Q_5$ and $Q_5'$ is controlled by a reset clock signal $\phi_R'$. The signal is pulled up to $V_{CC}$ at least after the writing operation of reverse data as indicated by $\phi_R'$ shown in Fig. 5A, in addition to the stand-by mode.

Therefore, during the stand-by mode (from $t_0$ to $t_1$), since the potentials of the bit lines $BL_1$ and $\overline{BL}_1$ are both $V_{CC}$, and in addition, the reset clock signal $\phi_R'$ is $V_{CC}+V_{th}+\alpha$, the potentials at the nodes $N_1$ and $N_2$ become the same as those of the bit lines due to the on-state of the transistors $Q_5$ and $Q_5'$. Therefore, during the stand-by mode the transistors $Q_5$ and $Q_5'$ serve the precharging function as performed by the transistors $Q_4$ and $Q_4'$ in Fig. 8.

In addition, when the reset clock signal $\phi_R'$ becomes $V_{CC}$ at least after the writing operation of reverse data, the potentials at the bit lines $BL_1$ and $\overline{BL}_1$ are transmitted to the nodes $N_1$ and $N_2$, respectively. That is, as shown in Fig. 5E or 5H, when the potential at the bit line $\overline{BL}_1$ rises after the writing of reverse data, the potential at the node $N_2$ which was low is also increased by the transistor $Q_5'$, however, it reaches $V_{CC}-V_{th}$ at most. On the other hand, the potential at the node $N_1$ remains at low level by the transistor $Q_2$ and $Q_5$. That is, also in this case, the higher potential, i.e., the potential at the bit line $\overline{BL}_1$ is transmitted to the node $N_2$ and in addition, the lower potential at the bit line $BL_1$ is also transmitted to the node $N_1$. Therefore, the transistors $Q_5$ and $Q_5'$ also serve the function of the transistors $Q_3$ and $Q_3'$ in Fig. 8. This reduces the number of transistors connected to the nodes $N_1$ and $N_2$ which work as loads when the potential at the node $N_1$ or $N_2$ is raised by the signal $\phi_{AP}$ through the capacitive coupling. The active pull-up circuit of Fig. 9 is, accordingly, advantageous in saving the necessary driving power of the clock signal $\phi_{AP}$.

As explained hereinbefore, according to the present invention, an active pulling-up operation is possible even when a write operation of reverse data is carried out.

## Claims

1. A semiconductor memory device comprising:

a power supply terminal ($V_{CC}$);

a plurality of pairs of bit lines ($BL_1$, $\overline{BL_1}$);

a plurality of sense amplifiers ($SA_1$), each connected to one pair of the pairs of bit lines for sensing the difference in potential between them;

a plurality of pairs of active pull-up circuits ($APU_1$, $APU_2$), each pair connected to one pair of bit lines, for pulling up the potential of the bit line having the highest potential of that pair;

wherein each of the active pull-up circuits ($APU_1$, $APU_2$) comprises:

a first transistor ($Q_1$, $Q_1'$) having a drain connected to the power supply terminal ($V_{CC}$), a source connected to a corresponding bit line ($BL_1$, $\overline{BL_1}$), and a gate;

a second transistor ($Q_2$, $Q_2'$) having a drain connected to the gate of the first transistor, a source connected to the corresponding bit line $BL_1$, $\overline{BL_1}$), and a gate connected to the other bit line ($\overline{BL_1}$, $BL_1$) of the pair containing the corresponding bit line ($BL_1$, $\overline{BL_1}$);

a capacitor ($C_1$, $C_1'$) having a first terminal connected to the gate of the first transistor ($Q_1$) and a second terminal; and,

means (Figure 6) connected to the second terminal of the capacitor, for generating an active pull-up signal ($\phi_{AP}$);

characterised in that the active pull-up circuit also includes means ($Q_3$, $Q_3'$; $Q_5$, $Q_5'$), connected to the gate of the first transistor ($Q_1$) and to the corresponding bit line ($BL_1$, $\overline{BL_1}$), for transmitting a high level potential of the corresponding bit line ($BL_1$, $\overline{BL_1}$) to the gate of the first transistor ($Q_1$).

2. A device according to claim 1, wherein the means connected to the gate of the first transistor ($Q_1$) and to the corresponding bit line ($BL_1$, $\overline{BL_1}$) comprises a gate-drain connected third transistor ($Q_3$, $Q_3'$).

3. A device according to claim 2, further comprising means for generating a reset clock signal ($\phi_R$) having a higher potential than that of the power supply terminal during a standby mode; and wherein each of the active pull-up circuits ($APU_1$, $APU_2$) comprises a fourth transistor ($Q_4$, $Q_4'$) for precharging the gate of the first transistor, the fourth transistor having a drain connected to the power supply terminal ($V_{CC}$), a source connected to the gate of the first transistor, and a gate for receiving the reset clock signal ($\phi_R$).

4. A device according to claim 1, wherein the means connected to the gate of the first transistor ($Q_1$) and to the corresponding bit line ($BL_1$, $\overline{BL_1}$) comprises a third transistor ($Q_5$, $Q_5'$) having a drain connected to the gate of the first transistor ($Q_1$), a source operatively connected to the corresponding bit line, and a gate for receiving a reset clock signal ($\phi_R'$) which is pulled up after the writing of reverse data.

## Patentansprüche

1. Halbleiterspeichervorrichtung mit:

einem Energieversorgungsanschluß ($V_{CC}$);

einer Vielzahl von Paaren von Bitleitungen ($BL_1$, $\overline{BL_1}$);

einer Vielzahl von Leseverstärkern ($SA_1$), von denen jeder mit einem Paar von den Paaren von Bitleitungen verbunden ist, um die Potentialdifferenz zwischen ihnen zu lesen;

einer Vielzahl von Paaren von aktiven pull-up-Schaltungen ($APU_1$, $APU_2$), von denen jedes Paar mit einem Paar von Bitleitungen verbunden ist, um das Potential der Bitleitung hochzuziehen, welches das höchste Potential von jenem Paar hat;

bei der jede der pull-up-Schaltungen ($APU_1$, $APU_2$) umfaßt:

einen ersten Transistor ($Q_1$, $Q_1'$), der ein Drain hat, das mit einem Energieversorgungsanschluß ($V_{CC}$) verbunden ist, eine Source, die mit einer entsprechenden Bitleitung ($BL_1$, $\overline{BL_1}$) verbunden ist; und ein Gate;

einen zweiten Transistor ($Q_2$, $Q_2'$), der ein Drain hat, das mit dem Gate des ersten Transistors verbunden ist, eine Source, die mit der entsprechenden Bitleitung ($BL_1$, $\overline{BL_1}$) verbunden ist, und ein Gate, das mit der anderen Bitleitung ($\overline{BL_1}$, $BL_1$) von dem Paar verbunden ist, welches die entsprechende Bitleitung ($BL_1$, $\overline{BL_1}$) enthält;

einen Kondensator ($C_1$, $C_1'$), welcher einen ersten Anschluß hat, der mit dem Gate des ersten Transistors ($Q_1$) verbunden ist, und einen zweiten Anschluß; und

Einrichtungen (Figur 6), die mit dem zweiten Anschluß des Kondensators verbunden sind, um ein aktives pull-up-Signal ($\phi_{AP}$) zu erzeugen;

dadurch gekennzeichnet, daß die aktive pull-up-Schaltung auch Einrichtungen ($Q_3$, $Q_3'$; $Q_5$, $Q_5'$) umfaßt, die mit dem Gate des ersten Transistors ($Q_1$) und mit der entsprechenden Bitleitung ($BL_1$, $\overline{BL_1}$) verbunden sind, um ein Hochpegelpotential der entsprechenden Bitleitung ($BL_1$, $\overline{BL_1}$) zu dem Gate des ersten Transistors ($Q_1$) zu übertragen.

2. Vorrichtung nach Anspruch 1, bei der die Einrichtung, die mit dem Gate des ersten Transistors ($Q_1$) und mit der entsprechenden Bitleitung ($BL_1$, $\overline{BL_1}$) verbunden ist, einen gate-drain-verbundenen Transistor ($Q_3$, $Q_3'$) umfaßt.

3. Vorrichtung nach Anspruch 2, ferner mit Einrichtungen zum Erzeugen eines Rücksetzsignals ($\phi_R$), welches ein höheres Potential als dasjenige des Energieversorgungsanschlusses während des Bereitschaftsmodus hat; und

bei der jede der aktiven pull-up-Schaltungen ($APU_1$, $APU_2$) einen vierten Transistor ($Q_4$, $Q_4'$) umfaßt, um das Gate des ersten Transistors vorzuladen, welcher vierte Transistor ein Drain hat, das mit dem Energieversorgungsanschluß ($V_{CC}$) verbunden ist, eine Source, die mit dem Gate des ersten Transistors verbunden ist, und ein Gate zum Empfangen des Rücksetzsignals ($\phi_R$).

4. Vorrichtung nach Anspruch 1, bei der die Einrichtung, die mit dem Gate des ersten Transistors ($Q_1$) und der entsprechenden Bitleitung ($BL_1$, $\overline{BL_1}$) verbunden ist, einen dritten Transistor ($Q_5$, $Q_5'$) umfaßt, der ein Drain hat, das mit dem Gate des ersten Transistors ($Q_1$) verbunden ist, eine Source, die wirkungsmäßig mit der entsprechenden Bitleitung verbunden ist, und ein Gate zum Empfangen eines Rücksetzsignals ($\phi_R'$), welches nach dem Schreiben von umgekehrten Daten hochgezogen wird.

**Revendications**

1. Dispositif de mémoire à semi-conducteurs, comprenant:

une borne d'alimentation ($V_{CC}$);

plusieurs paires de lignes de bit ($BL_1$, $\overline{BL_1}$);

plusieurs amplificateurs de détection ($SA_1$) connectés chacun à l'une des paires de lignes de bit pour détecter la différence en potentiel entre elles;

plusieurs paires de circuits de relèvement actif ($APU_1$, $APU_2$), chaque paire étant connectée à une paire de lignes de bit, pour relever le potentiel de la ligne de bit présentant le potentiel le plus élevé de cette paire de lignes;

dans lequel chacun des circuits de relèvement actif ($APU_1$, $APU_2$) comprend:

un premier transistor ($Q_1$, $Q_1'$), possédant un drain relié à la borne d'alimentation ($V_{CC}$), une source reliée à une ligne de bit correspondante ($BL_1$, $\overline{BL_1}$) et une grille;

un second transistor ($Q_2$, $Q_2'$) possédant un drain relié à la grille du premier transistor, une source reliée à la ligne de bit correspondante ($BL_1$, $\overline{BL_1}$) et une grille reliée à l'autre ligne de bit de la paire contenant la ligne de bit correspondante ($BL_1$, $\overline{BL_1}$);

un condensateur ($C_1$, $C_1'$) possédant une première borne reliée à la grille du premier transistor ($Q_1$) et une seconde borne; et

un moyen (figure 6) relié à la seconde borne du condensateur et servant à générer un signal de relèvement actif ($\phi_{AP}$);

caractérisé en ce que le circuit de relèvement actif comprend également un moyen ($Q_3$, $Q_3'$; $Q_5$, $Q_5'$) relié à la grille du premier transistor ($Q_1$) et à la ligne de bit correspondante ($BL_1$, $\overline{BL_1}$) et destiné à transmettre un potentiel de niveau élevé de la ligne de bit correspondante ($BL_1$, $\overline{BL_1}$) à la grille du premier transistor ($Q_1$).

2. Dispositif selon la revendication 1, dans lequel le moyen relié à la grille du premier transistor ($Q_1$) et à la ligne de bit correspondante ($BL_1$, $\overline{BL_1}$) est constitué par un troisième transistor ($Q_3$, $Q_3'$) dont la grille et le drain sont reliés l'un à l'autre.

3. Dispositif selon la revendication 2, comprenant en outre un moyen pour générer un signal d'horloge de remise à zéro ($\phi_R$) ayant un potentiel plus élevé qui celui de la borne d'alimentation pendant un mode d'attente; et

dans lequel chacun des circuits de relèvement actif ($APU_1$, $APU_2$) comprend un quatrième transistor ($Q_4$, $Q_4'$) pour précharger la grille du premier transistor, le quatrième transistor possédant un drain relié à la borne d'alimentation ($V_{CC}$), une source reliée à la grille du premier transistor et une grille destinée à recevoir le signal d'horloge de remise à zéro ($\phi_R$).

4. Dispositif selon la revendication 1, dans lequel le moyen relié à la grille du premier transistor ($Q_1$) et à la ligne de bit correspondante ($BL_1$, $\overline{BL_1}$) est constitué par un troisième transistor ($Q_5$, $Q_5'$) possédant un drain relié à la grille du premier transistor ($Q_1$), une source reliée fonctionnellement à la ligne de bit correspondante et une grille destinée à recevoir un signal d'horloge de remise à zéro ($\phi_R'$) et dont le potentiel est relevé après l'inscription de données à rebours.

# Fig. 1

Fig. 2

Fig. 3A

Fig. 3B

Fig. 3C

Fig. 3D

Fig. 3E

Fig. 3F

STAND-BY MODE

SELECTING MODE

SENSING MODE

PULLING-UP MODE

$t_0$  $t_1$  $t_2$  $t_3$  $t_4$  $t_5$

$V_{cc}+V_{th}+\alpha$   0   $\phi_R$

$V_{cc}+V_{th}+\alpha$   0   $WL_1, DWL_2$

$V_{cc}$   0   $\phi_{LE}$

$V_{cc}$   0   $\phi_{AP}$

$V_{cc}$   0   $BL_1$   $\overline{BL_1}$   $\Delta V$   $\overline{BL_1}$

$V_{cc}-V_{th}$   0   $N_1$   $N_2$

Fig. 4

Fig. 5A

Fig. 5B

Fig. 5C

Fig. 5D

Fig. 5E

Fig. 5F

Fig. 5G

Fig. 5H

Fig. 5I

$t_0$  $t_1$  $t_2$  $t_3$  $t_4$  $t_5$

STAND-BY MODE | SELECTING MODE

SENSING MODE

$Vcc+Vth+\alpha$
$Vcc$
O
$\phi_R(\phi_R')$
PULLING-UP MODE
$\phi_R'$
PULLING-UP MODE

$Vcc+Vth+\alpha$
O
$WL_1, DWL_2$

$Vcc$
O
$\phi_{LE}$

$Vcc$
O
$BL_1$
$\phi_{AP}$
$\phi_{AP}$

$Vcc$
O
$\overline{BL_1}$
$\overline{BL_1}$

$Vcc$
$Vcc-Vth$
O
$X_1$
$N_1$
$N_2$
$N_2$

$Vcc$
O
$BL_1$
$\phi_{AP}$
PULLING-UP MODE $t_7$
$t_8$ PULLING-UP MODE

$Vcc$
O
$\overline{BL_1}$
$\overline{BL_1}$

$Vcc$
$Vcc-Vth$
O
$X_2$
$N_1$
$N_2$
$N_2'$
$N_1$

EP 0 114 492 B1

*Fig. 6*

*Fig.7A* $\phi_{LE}$

*Fig.7B* $\overline{WE}'$

*Fig.7C* $N_3$

*Fig.7D* $N_4$

*Fig.7E* $N_5$

*Fig.7F* $N_6$

*Fig.7G* $N_7$

*Fig.7H* $N_8$

*Fig.7I* $\phi_{AP}$

# Fig. 8

*Fig. 9*